# EUROPEAN PATENT APPLICATION

(11) **EP 4 016 010 A1**
(43) Date of publication of application: **22.06.2022**
(21) Application number: 20852660.8
(22) Date of filing: 20.07.2020
(51) Int. Cl.: G01D 5/353

(54) **OPTICAL FIBER SENSING SYSTEM, OPTICAL FIBER SENSING DEVICE, AND POWER OUTAGE DETECTION METHOD**

(30) Priority: 13.08.2019 JP 2019148297
(71) Applicant: NEC Corporation, 108-8001 Tokyo (JP)
(72) Inventor: YODA Yukihide, Tokyo 108-8001 (JP); OGURA Naoto, Tokyo 108-8001 (JP); AONO Yoshiaki, Tokyo 108-8001 (JP)
(74) Representative: Reeve, Nicholas Edward
(86) International application number: PCT/JP2020/028009
(87) International publication number: WO 2021/029186

(57) **Abstract**

An optical fiber sensing system according to the present disclosure includes an optical fiber (10), a reception unit (21) configured to receive, from the optical fiber (10), an optical signal including an environment pattern indicating a state of an environment in proximity to the optical fiber (10), and a detection unit (22) configured to detect an occurrence of a power outage, based on a change in the environment pattern.

## Description

### Technical Field

The present disclosure relates to an optical fiber sensing system, optical fiber sensing equipment, and a power outage detection method.

### Background Art

In a case where a disaster such as an earthquake occurs, various damages may occur. In addition, in a case where damage occurs, it is necessary to recover to a state before the damage, and therefore, it is necessary to detect whether or not damage has actually occurred within the range where the disaster occurred. For example, PTL 1 describes a technique for detecting river levee breach by using an optical fiber as a sensor.

### Citation List

### Patent Literature

Patent Literature 1: Japanese Unexamined Patent Application Publication No. 2001-249035

### Summary of Invention

### Technical Problem

By the way, in a case where a disaster occurs, a power outage may occur. In a case where a power outage occurs, it is necessary to recover, but it is difficult to actually ascertain whether a power outage has occurred.

Accordingly, it is an object of the present disclosure to provide an optical fiber sensing system, optical fiber sensing equipment, and a power outage detection method capable of solving the above problem and detecting a power outage when a disaster occurs.

### Solution to Problem

An optical fiber sensing system according to an aspect includes:
an optical fiber;
a reception unit configured to receive, from the optical fiber, an optical signal including an environment pattern indicating a state of an environment in proximity to the optical fiber; and
a detection unit configured to detect an occurrence of a power outage, based on a change in the environment pattern.

An optical fiber sensing equipment according to an aspect includes:
a reception unit configured to receive, from an optical fiber, an optical signal including an environment pattern indicating a state of an environment in proximity to the optical fiber; and
a detection unit configured to detect an occurrence of a power outage, based on a change in the environment pattern.

A power outage detection method according to an aspect is a power outage detection method achieved with an optical fiber sensing system, comprising:
a reception step of receiving, from an optical fiber, an optical signal including an environment pattern indicating a state of an environment in proximity to the optical fiber; and
a detection step of detecting an occurrence of a power outage, based on a change in the environment pattern.

### Advantageous Effects of Invention

According to the above-described aspects, it is possible to obtain the effect of capable of providing an optical fiber sensing system, optical fiber sensing equipment, and a power outage detection method capable detecting a power outage when a disaster occurs can be provided.

### Brief Description of Drawings

Fig. 1 is a diagram illustrating a configuration example of an optical fiber sensing system according to a first example embodiment.
Fig. 2 is a diagram illustrating an example of a method in which a detection unit according to the first example embodiment detects an occurrence of a power outage.
Fig. 3 is a diagram illustrating an example of a method in which the detection unit according to the first example embodiment detects an occurrence of a power outage.
Fig. 4 is a flowchart illustrating an operation example of an optical fiber sensing system according to the first example embodiment.
Fig. 5 is a diagram illustrating an example of a method in which a detection unit according to a second example embodiment identifies a power outage occurrence area.
Fig. 6 is a diagram illustrating an example of a correspondence table stored in a case where the detection unit according to the second example embodiment performs the method of Fig. 5.
Fig. 7 is a diagram illustrating an example of a method in which the detection unit according to the second example embodiment identifies a power outage occurrence area.
Fig. 8 is a diagram illustrating an example of a correspondence table stored in a case where the detection unit according to the second example embodiment performs the method of Fig. 7.
Fig. 9 is a diagram illustrating an example of a method in which the detection unit according to the second example embodiment identifies a power outage occurrence area.
Fig. 10 is a diagram illustrating an example of a correspondence table stored in a case where the detection unit according to the second example embodiment performs the method of Fig. 9.
Fig. 11 is a flowchart illustrating an operation example of an optical fiber sensing system according to the second example embodiment.
Fig. 12 is a diagram illustrating a configuration example of an optical fiber sensing system according to a third example embodiment.
Fig. 13 is a diagram illustrating an example of a GUI screen which a notification unit according to the third example embodiment causes to be displayed on a display unit.
Fig. 14 is a diagram illustrating an example of a GUI screen which the notification unit according to the third example embodiment causes to be displayed on the display unit.
Fig. 15 is a diagram illustrating an example of a GUI screen which the notification unit according to the third example embodiment causes to be displayed on the display unit.
Fig. 16 is a diagram illustrating an example of a GUI screen which the notification unit according to the third example embodiment causes to be displayed on the display unit.
Fig. 17 is a flowchart illustrating an operation example of the optical fiber sensing system according to the third example embodiment.
Fig. 18 is a diagram illustrating a configuration example of an optical fiber sensing system according to another embodiment.
Fig. 19 is a block diagram illustrating an example of a hardware configuration of a computer that achieves optical fiber sensing equipment according to the example embodiments.

### Description of Embodiments

The following will describe example embodiments of the present disclosure with reference to the drawings. Note that the following descriptions and drawings have been abbreviated and simplified as appropriate for clarity of explanation. Further, in each of the following drawings, the same elements are designated by the same reference numerals, and duplicate explanations are omitted where necessary.

### <First Embodiment>

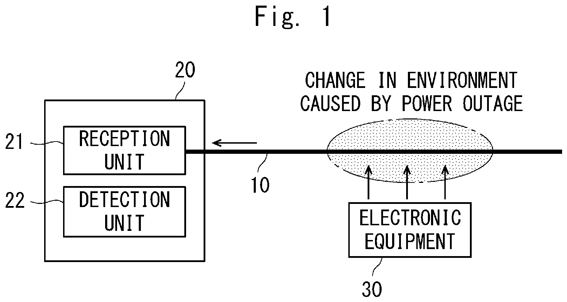

First, a configuration example of an optical fiber sensing system according to a first example embodiment is explained with reference to Fig. 1.

As illustrated in Fig. 1, the optical fiber sensing system according to the first example embodiment includes an optical fiber 10 and optical fiber sensing equipment 20. Further, the optical fiber sensing equipment 20 includes a reception unit 21 and a detection unit 22.

One end of the optical fiber 10 is connected to the optical fiber sensing equipment 20. The optical fiber 10 may be an optical fiber dedicated for sensing or may be an optical fiber used for both of communication and sensing. In a case where the optical fiber 10 is an optical fiber used for both of communication and sensing, an optical signal for sensing is demultiplexed by a filter, so that only the optical signal for sensing can be received by the optical fiber sensing equipment 20.

The reception unit 21 receives an optical signal (i.e., an optical signal for sensing, the same applies below) from the optical fiber 10. For example, the reception unit 21 injects pulsed light into the optical fiber 10, and also receives the back scattered light, which is generated in response to transmission of the pulsed light through the optical fiber 10, as an optical signal. Alternatively, the reception unit 21 receives, as an optical signal, the pulsed light injected into the optical fiber 10 by an apparatus provided to oppose the optical fiber sensing equipment 20.

In this case, electronic equipment 30 is provided in proximity to the optical fiber 10. The electronic equipment 30 is equipment of which the operation state changes during a power outage. For example, the electronic equipment 30 is equipment that operates when a power outage does not occur, and stops its operation during a power outage. Examples of electronic equipment 30 that operates when a power outage does not occur are considered to include refrigerators, air conditioners, factory equipment, and the like, but are not limited to thereto. Alternatively, the electronic equipment 30 is equipment that stops its operation when a power outage does not occur, and operates during a power outage. Examples of electronic equipment 30 that operates during a power outage are considered to include emergency power supplies and the like, but are not limited to thereto.

In a case where the above-described electronic equipment 30 is provided in proximity to the optical fiber 10, the state of the environment in proximity to the optical fiber 10 changes during a power outage.

For example, the electronic equipment 30 that operates when a power outage does not occur stops its operation during a power outage. Accordingly, in proximity to the optical fiber 10, there occurs a change in the environment such as a stop of vibration (including sound, the same applies below), a decrease or an increase in the temperature, uniformization of temperature distribution, and the like due to the stop of the operation of the electronic equipment 30.

Furthermore, electronic equipment 30 that stops its operation when a power outage does not occur operates during a power outage. Accordingly, in proximity to the optical fiber 10, there occurs a change in the environment such as an occurrence of vibration, an increase in the temperature, deviation of temperature distribution, and the like due to the operation of the electronic equipment 30.

When at least one of vibration change and temperature change occurs in proximity to the optical fiber 10, the wavelength of the optical signal transmitted through the optical fiber 10 changes in accordance with the at least one of the vibration change and the temperature change that occurred in proximity to the optical fiber 10. Therefore, the optical signal received by the reception unit 21 includes an environment pattern indicating the state of the environment such as the vibration and the temperature in proximity to the optical fiber 10. This environment pattern may indicate the state of at least one of the vibration and the temperature in proximity to the optical fiber 10.

Therefore, the detection unit 22 can detect a change in the state of the environment, i.e., an occurrence of a power outage, in proximity to the optical fiber 10, by analyzing the change in the environment pattern included in the optical signal received by the reception unit 21.

Accordingly, in the first example embodiment, the detection unit 22 detects an occurrence of a power outage on the basis of a change in the environment pattern included in the optical signal received by the reception unit 21.

The detection unit 22 can identify the position where the environment pattern has changed (i.e., a distance of the optical fiber 10 from the optical fiber sensing equipment 20) on the basis of the optical signal received by the reception unit 21. For example, in a case where the reception unit 21 is configured to receive back scattered light from the optical fiber 10 as an optical signal, the detection unit 22 can identify the position where the environment pattern has changed, on the basis of a time difference between a time at which the reception unit 21 injects a pulsed light into the optical fiber 10 and a time at which the reception unit 21 receives an optical signal including a changed environment pattern. Also, the detection unit 22 may compare, for each distance of the optical fiber 10 from the optical fiber sensing equipment 20, an intensity of a vibration that is detected at that distance and that includes a changed environment pattern, and can identify, as the position where the environment pattern has changed, a position at a distance where the intensity of the vibration is the largest. Also, the detection unit 22 can identify the position where the environment pattern has changed, on the basis of an intensity of an optical signal including a changed environment pattern. For example, in accordance with a decrease in the intensity of the received optical signal, the detection unit 22 identifies, as the position where the environment pattern has changed, a position that is accordingly farther from the reception unit 21.

Hereinafter, an example of a method in which the detection unit 22 detects an occurrence of a power outage on the basis of a change in an environment pattern included in the optical signal received by the reception unit 21 will be explained.

### (A1) Method A1

First, the method A1 will be explained.

In the method A1, it is assumed that the reception unit 21 is configured to receive, as an optical signal, back scattered light from the optical fiber 10, and it is assumed that a time difference between a time at which the reception unit 21 injects pulsed light and a time at which the reception unit 21 receives, as an optical signal, back scattered light corresponding to the pulsed light is denoted as Δt.

At times t1, t2, the reception unit 21 injects pulsed light into the optical fiber 10, and at times t1+Δt, t2+Δt, the reception unit 21 receives optical signals from the optical fiber 10.

The detection unit 22 compares the waveform patterns of the optical signals received by the reception unit 21 at the times t1+Δt, t2+Δt, and in a case where the change in the waveform patterns represent a change in an environment caused by a power outage in proximity to the optical fiber 10, the detection unit 22 determines that the environment pattern has changed and the power outage has occurred. The detection unit 22 can detect at least one of the quantity of change of vibration and the quantity of change of the temperature from the quantity of change of the environment pattern.

### (A2) Method A2

Next, the method A2 will be explained.

In the method A2, the detection unit 22 stores a waveform pattern of an optical signal in advance. In this case, for example, when the electronic equipment 30 is equipment that operates when a power outage does not occur, the detection unit 22 stores the waveform pattern of the optical signal obtained while the electronic equipment 30 is operating. The waveform pattern of the optical signal obtained while the electronic equipment 30 is operating corresponds to, for example, a vibration caused by the operation of the electronic equipment 30, a temperature adjusted by a temperature adjustment function of the electronic equipment 30, or the like.

In contrast, when the electronic equipment 30 is equipment that operates during a power outage, the detection unit 22 stores, in advance, the waveform pattern of the optical signal obtained while the electronic equipment 30 stops its operation.

The detection unit 22 compares the waveform pattern of the optical signal received by the reception unit 21 with the waveform pattern stored in advance, and in a case where a change occurs in a pattern that does not include the waveform pattern stored in advance, the detection unit 22 determines that the environment pattern has changed and the power outage has occurred. The detection unit 22 can detect at least one of the quantity of change of vibration and the quantity of change of the temperature from the quantity of change of the environment pattern.

### (A3) Method A3

Next, the method A3 will be explained.

The method A3 is an example in which the electronic equipment 30, i.e., air conditioning equipment, is provided in proximity to the optical fiber 10. In this case, with the temperature adjustment function, the electronic equipment 30 can maintain the temperature in proximity to the optical fiber at a constant level. When the operation of the electronic equipment 30 stops, the vibration transmitting from the electronic equipment 30 to the optical fiber 10 stops, and accordingly, the temperature adjustment stops. Also, even in a case where a power outage does not occur, the electronic equipment 30 is stopped if the temperature adjustment is not needed.

In the method A3, the detection unit 22 detects a power outage on the basis of a change in the vibration of the optical fiber included in the environment pattern and the temperature. Specifically, in a case where the detection unit 22 detects a stop of vibration caused by a stop of the operation of the electronic equipment 30 and where the quantity of change of the temperature is equal to or more than a predetermined range, the detection unit 22 determines that a power outage has occurred. Conversely, in a case where the quantity of change of the temperature is less than the predetermined range even in a case where the detection unit 22 detects a stop of vibration caused by a stop of the operation of the electronic equipment 30, the detection unit 22 determines that the electronic equipment 30 has been stopped because the temperature adjustment is not needed, and does not determine that a power outage has occurred.

In the method A3, for example, at least one of the above-described methods A1 and A2 is used for the detection of a stop of vibration and the detection of the quantity of change of the temperature.

At this occasion, the detection unit 22 may determine that a power outage has occurred in a case where the position where the environment pattern has changed due to the change of vibration matches with the position where the environment pattern has changed due to the change in the temperature.

In the method A3, the detection unit 22 detects a power outage on the basis of both of the change of the vibration and the change of the temperature, and therefore, the detection unit 22 can detect a power outage more accurately.

### (A4) Method A4

Next, the method A4 will be explained.

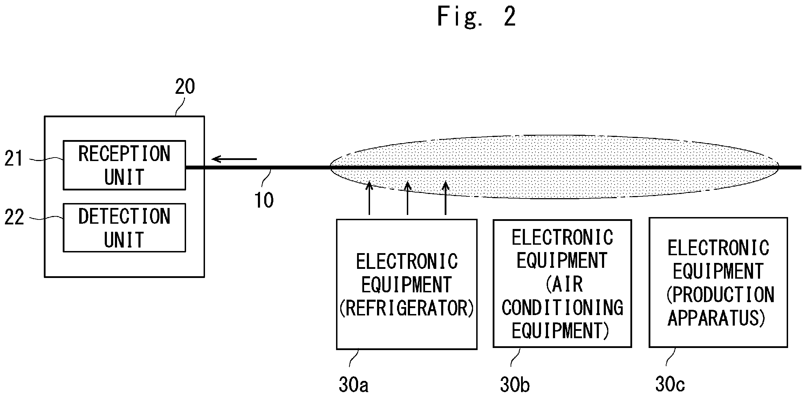

The method A4 is an example in which multiple pieces of electronic equipment 30 are provided in proximity to the optical fiber 10. In this case, as illustrated in Fig. 2, an example will be explained in which three pieces of electronic equipment 30 that are electronic equipment 30a, i.e., a refrigerator, electronic equipment 30b, i.e., air conditioning equipment, and electronic equipment 30c, i.e., a production apparatus, are provided in proximity to the optical fiber 10.

In the method A4, first, the detection unit 22 determines whether the respective environment patterns of the three pieces of electronic equipment 30a to 30c provided in proximity to the optical fiber 10 have changed or not. The method for identifying the positions of the electronic equipment 30a to 30c where environment patterns have changed (the distances of the optical fiber 10 from the optical fiber sensing equipment 20) in a case where the environment patterns have changed is as described above.

Then, in a case where the changes of the three environment patterns satisfy a predetermined condition, the detection unit 22 determines that a power outage has occurred.

For example, in a case where, from among the three environment patterns, environment patterns equal to or more than a predetermined number (for example, two) have changed or a predetermined rate (for example, 50%) or more of environment patterns have changed, the detection unit 22 determines that a power outage has occurred.

Alternatively, in a case where all of the three environment patterns have changed, the detection unit 22 determines that a power outage has occurred.

Alternatively, in a case where, from among the electronic equipment 30a to 30c, an environment pattern of electronic equipment 30 of a higher degree of priority has changed, the detection unit 22 determines that a power outage has occurred. For example, the electronic equipment 30b is the air conditioning equipment and the electronic equipment 30c is the production apparatus, and therefore, the electronic equipment 30b, 30c may stop operations even when a power outage does not occur. For example, the production apparatus is stopped at the end of the operation hours of a factory and the like. In contrast, the electronic equipment 30a that is the refrigerator is less likely to stop its operation when a power outage does not occur, and therefore, a higher degree of priority is given to the electronic equipment 30a. In this case, when the environment pattern of the electronic equipment 30a of the high degree of priority has changed, the detection unit 22 determines that a power outage has occurred even if the environment pattern of any one of the electronic equipment 30b, 30c has not changed. Conversely, when the environment pattern of the electronic equipment 30a of the high degree of priority has not changed even if the environment pattern of any one of the electronic equipment 30b, 30c has changed, the detection unit 22 does not determine that a power outage has occurred.

In this manner, in the method A4, an occurrence of a power outage is detected in accordance with whether changes in the environmental patterns of multiple pieces of electronic equipment 30 provided in proximity to the optical fiber 10 satisfy the predetermined condition, and therefore, as compared with a method for detecting an occurrence of a power outage on the basis of a change in the environment pattern of only one piece of electronic equipment 30, an occurrence of a power outage can be detected with a higher degree of accuracy.

As described above, the electronic equipment such as air conditioning equipment, a production apparatus, and the like may stop its operation even when a power outage does not occur. Therefore, such electronic equipment may be used as electronic equipment 30 only during the operating time period. In a time period other than the operating time period, electronic equipment such as a refrigerator that is less likely to stops its operation when a power outage does not occur or electronic equipment such as an emergency power supply that operates during a power outage may be used as electronic equipment 30.

### (A5) Method A5

Next, the method A4 will be explained.

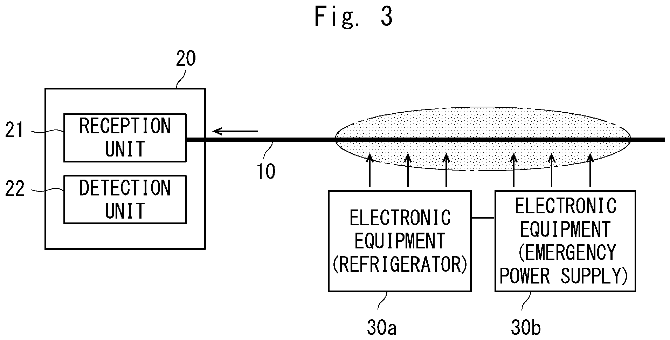

The method A4 is an example in which electronic equipment 30 that operates during a power outage and electronic equipment 30 that operates when a power outage does not occur are provided in proximity to the optical fiber 10. In this case, as illustrated in Fig. 3, an example will be explained in which, in proximity to the optical fiber 10, electronic equipment 30b, i.e., an emergency power supply, is provided as the electronic equipment 30 that operates during a power outage, and electronic equipment 30a, i.e., a refrigerator, is provided as the electronic equipment 30 that operates when a power outage does not occur.

In the method A5, the detection unit 22 determines whether an environment pattern of the electronic equipment 30b, i.e., the emergency power supply, provided in proximity to the optical fiber 10 has changed, and in a case where the environment pattern has changed, the detection unit 22 determines that a power outage has occurred.

Also, when the electronic equipment 30b operates due to an occurrence of a power outage, a power is supplied from the electronic equipment 30b to the electronic equipment 30a, i.e., the refrigerator. Therefore, the environment pattern of the electronic equipment 30a temporarily changes due to an occurrence of a power outage, but thereafter returns back to the original pattern.

Therefore, the detection unit 22 determines that the power is supplied normally from the electronic equipment 30b, i.e., the emergency power supply, to the electronic equipment 30a, i.e., the refrigerator.

Accordingly, the detection unit 22 can determine not only that a power outage has occurred but also that the power is supplied normally from the electronic equipment 30b, i.e., the emergency power supply.

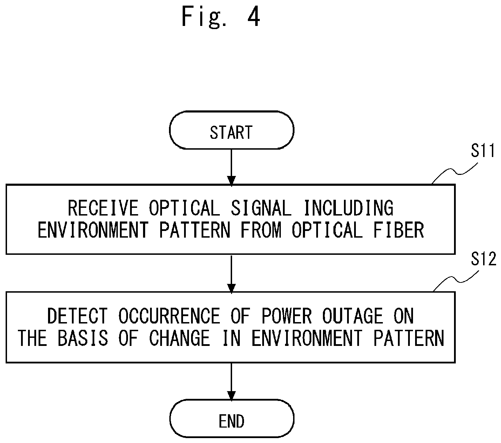

Next, an example of operation of an optical fiber sensing system according to the first example embodiment is explained with reference to Fig. 4.

As illustrated in Fig. 4, the reception unit 21 receives, from the optical fiber 10, an optical signal including an environment pattern indicating the state of the environment in proximity to the optical fiber 10 (step S11).

Subsequently, the detection unit 22 detects an occurrence of a power outage on the basis of a change in the environment pattern included in the optical signal received by the reception unit 21 (step S12). For example, this detection may be performed by suing any one of the above-described methods A1 to A5.

As described above, according to this first example embodiment, an optical signal including the environment pattern indicating the state of the environment in proximity to the optical fiber 10 is received from the optical fiber 10. The detection unit 22 detects an occurrence of a power outage on the basis of a change in the environment pattern included in the optical signal. Therefore, a power outage can be detected when a disaster occurs.

### <Second Embodiment>

The configuration of an optical fiber sensing system according to this second example embodiment is substantially the same as the configuration of the above-described second example embodiment, but the function of the detection unit 22 is expanded.

As described above, the detection unit 22 can identify the position where the environment pattern has changed (the distance of the optical fiber 10 from the optical fiber sensing equipment 20) on the basis of the optical signal received by the reception unit 21.

Therefore, in a case where the detection unit 22 determines that a power outage has occurred, the detection unit 22 identifies a power outage occurrence position that is a position where a power outage has occurred and a power outage occurrence area that an area where a power outage has occurred, on the basis of the position where the environment pattern has changed.

With the power outage occurrence positions, the detection unit 22 identifies, as the power outage occurrence positions, the position where the environment patterns have changed.

Therefore, hereinafter, an example of a method in which the detection unit 22 identifies a power outage occurrence area on the basis of the position where the environment pattern has changed will be explained.

### (B1) Method B1

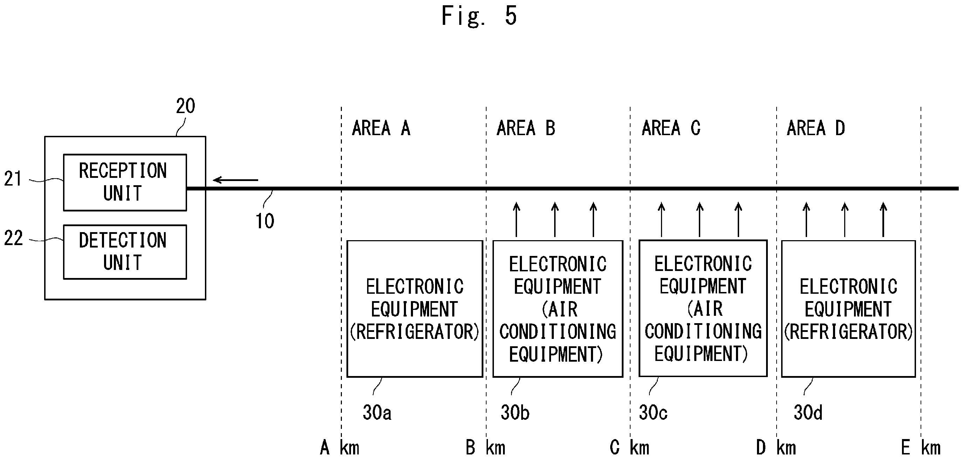

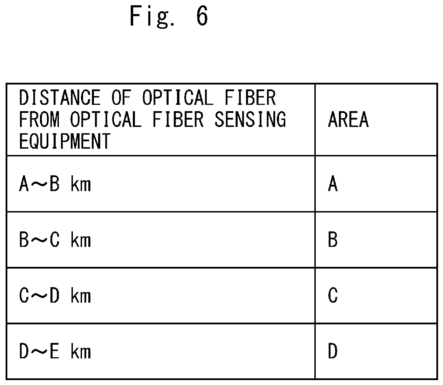

First, the method B1 will be explained with reference to Fig. 5 and Fig. 6.

In the example of Fig. 5, an area in which the optical fiber 10 is installed is divided into four areas A to D. Also, electronic equipment 30a to 30d are provided in the areas A to D, respectively.

In the case of the example of Fig. 5, as illustrated in Fig. 6, the detection unit 22 stores, in advance, a correspondence table for associating a distance of the optical fiber 10 from the optical fiber sensing equipment 20 with an area corresponding to that distance.

For example, in a case where the environment pattern of the electronic equipment 30a has changed, the distance of the optical fiber 10 from the optical fiber sensing equipment 20 to the position where the environment pattern has changed is in a range of A to B [km]. In this case, the detection unit 22 identifies the area A as the power outage occurrence area by referring to the correspondence table of Fig. 6.

### (B2) Method B2

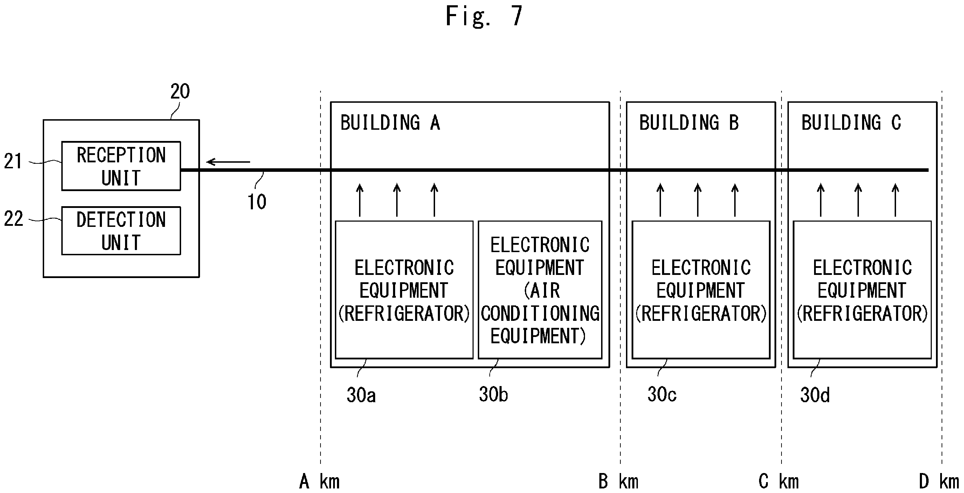

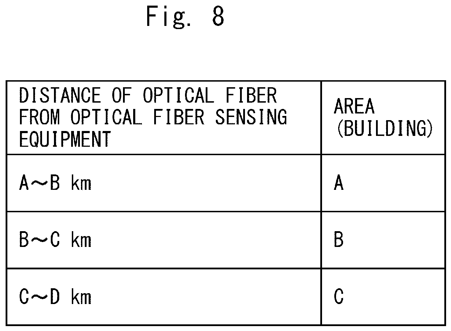

Next, the method B2 is explained with reference to Fig. 7 and Fig. 8.

The units in which an area is divided is not particularly limited. The method B2 is an example for dividing an area in units of buildings, for example, as illustrated in Fig. 7.

In the example of Fig. 7, the area in which the optical fiber 10 is installed is divided into three buildings A to C. Electronic equipment 30a, 30b are provided in the building A, electronic equipment 30c is provided in the building B, and electronic equipment 30d is provided in the building C. An example of a correspondence table in the case of the example of Fig. 7 is illustrated in Fig. 8.

In the example of Fig. 7, two pieces of electronic equipment 30a, 30b are provided in the building A. In this case, it is assumed that the detection unit 22 already finds in advance that the two pieces of electronic equipment 30a, 30b are provided in the building A. Therefore, when an occurrence of a power outage in the building A is detected, the detection unit 22 uses the above-described method A3. Specifically, the detection unit 22 determines whether respective environment patterns of the two pieces of electronic equipment 30a, 30b have changed, and in a case where changes in the two environment patterns satisfy a predetermined condition, the detection unit 22 determines that a power outage has occurred.

### (B3) Method B3

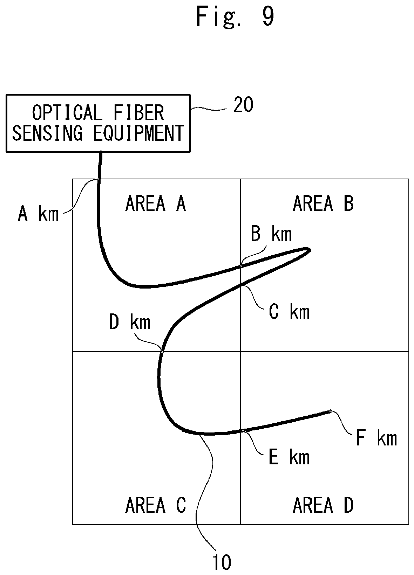

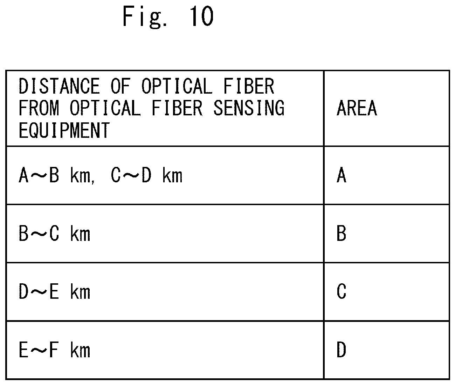

Next, the method B3 is explained with reference to Fig. 9 and Fig. 10.

The above-described methods B1, B2 are examples in which the optical fiber 10 is installed in a linear manner. The method B3 is an example in which the optical fiber 10 is installed such that it is bent and folded on the way, for example, as illustrated in Fig. 9. An example of a correspondence table in the case of the example of Fig. 9 is illustrated in Fig. 10. The method B3 is different from the above-described methods B1, B2 in the installation method of the optical fiber 10, but the method for identifying the power outage occurrence area may be substantially the same as the above-described methods B1, B2.

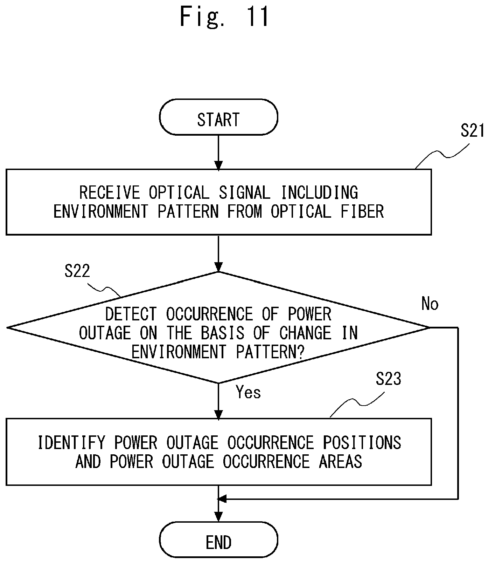

Next, an example of operation of an optical fiber sensing system according to this second example embodiment is explained with reference to Fig. 11.

As illustrated in Fig. 11, first, steps S21 to S22 that are substantially the same as steps S11 to S12 of Fig. 4 are performed.

In a case where the detection unit 22 determines that a power outage has occurred in step S22 (Yes in step S22), then, the detection unit 22 identifies the position where the environment pattern has changed, and further, identifies the power outage occurrence positions and the power outage occurrence areas on the basis of the positions where the environment patterns have changed (step S23). For example, the power outage occurrence position may be identified as the position where the environment pattern has changed. Also, the power outage occurrence area may be identified by using any one of the above-described methods B1 to B3.

As described above, according to this second example embodiment, in a case where the detection unit 22 determines that a power outage has occurred, the detection unit 22 identifies the power outage occurrence positions and the power outage occurrence areas on the basis of the position where the environment pattern has changed. Accordingly, not only an occurrence of a power outage can be detected but also the power outage occurrence positions and the power outage occurrence areas where power outages have occurred can be detected. Other effects are substantially the same as the above-described the first example embodiment.

### <Third Embodiment>

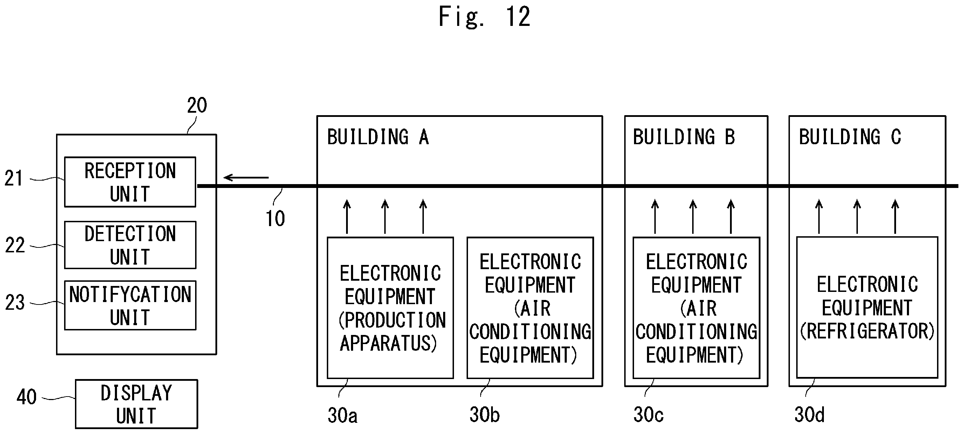

Next, a configuration example of an optical fiber sensing system according to this third example embodiment is explained with reference to Fig. 12. Like Fig. 7, Fig. 12 is an example in a case where the area in which the optical fiber 10 is installed is divided into three buildings A to C.

As illustrated in Fig. 12, as compared with the above-described the first and second example embodiments, the optical fiber sensing system according to this third example embodiment is different in that a display unit 40 is additionally provided and a notification unit 23 is additionally provided in the optical fiber sensing equipment 20.

The display unit 40 is provided in a communication station building, an operation center, and the like, and is a display, a monitor, and the like for displaying various kinds of information.

The notification unit 23 stores in advance information indicating the position where the optical fiber 10 is installed and map information such that the information and the map information are associated with each other. Then, in a case where the detection unit 22 determines that a power outage has occurred, the notification unit 23 causes the display unit 40 to display a GUI (Graphical User Interface) screen in which information of either the power outage occurrence positions or the power outage occurrence areas, or both, identified by the detection unit 22 is superimposed on the map information.

Hereinafter, an example of a GUI screen displayed on the display unit 40 with the notification unit 23 is explained. Note that the map on the GUI screen described below can be enlarged and reduced as needed.

### (C1) GUI screen C1

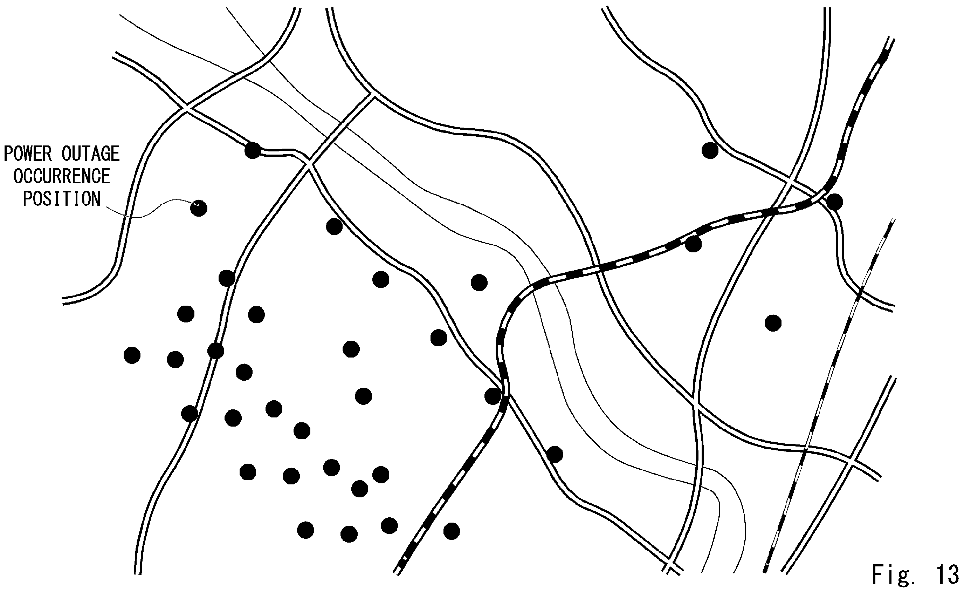

As illustrated in Fig. 13, the GUI screen C1 is a screen in which the power outage occurrence positions are superimposed on the map. In Fig. 13, the power outage occurrence positions are indicated by black dots on the map.

### (C2) GUI screen C2

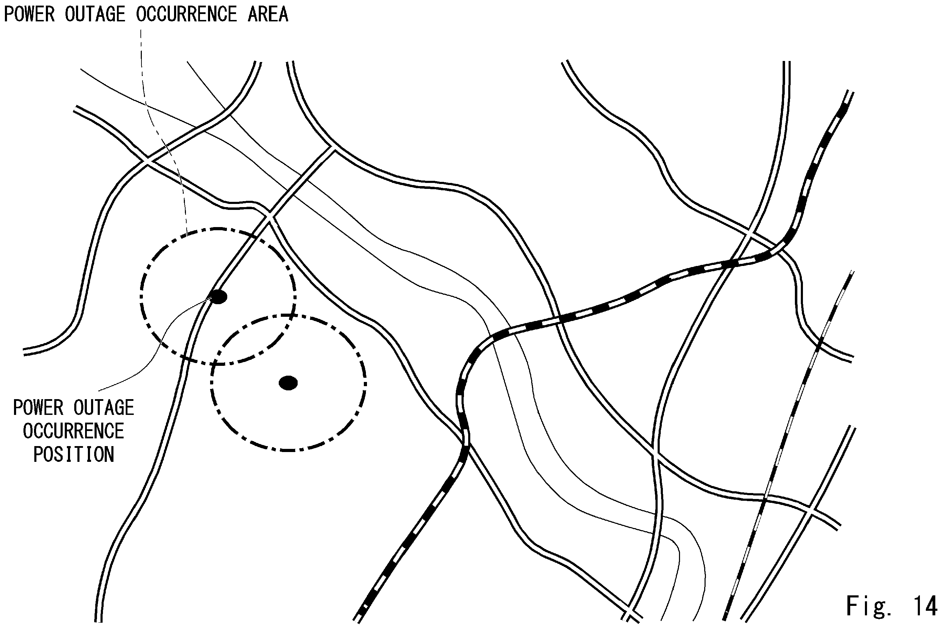

As illustrated in Fig. 14, the GUI screen C2 is a screen in which the power outage occurrence positions and the power outage occurrence areas are superimposed on the map. In Fig. 14, the power outage occurrence positions are indicated by black dots on the map. Also, the power outage occurrence areas are indicated by circles including the power outage occurrence positions on the map. In Fig. 14, the power outage occurrence positions and the power outage occurrence areas are superimposed on the map, but the power outage occurrence positions may not be superimposed, and only the power outage occurrence areas may be superimposed.

### (C3) GUI screen C3

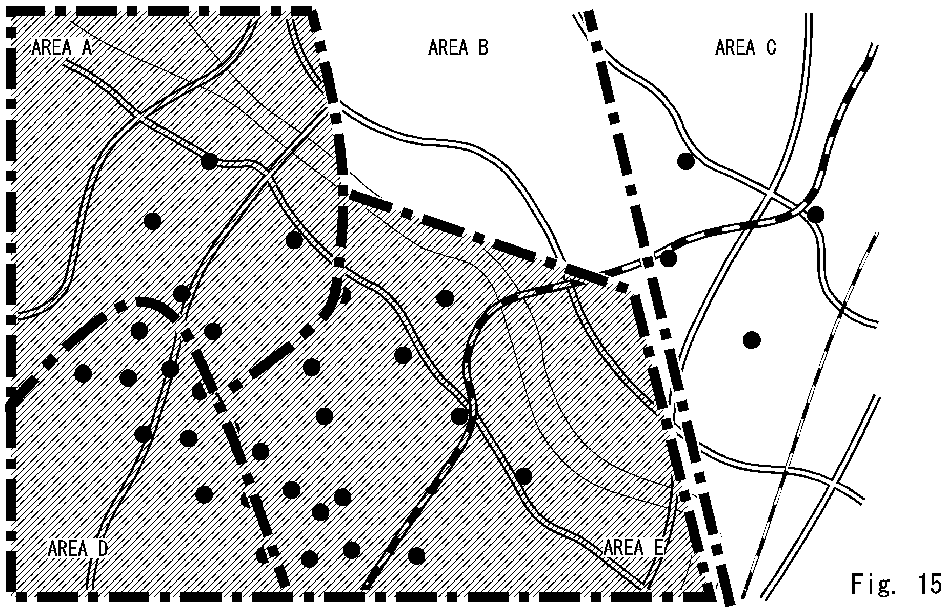

As illustrated in Fig. 15, the GUI screen C3 is a screen in which the power outage occurrence positions and the power outage occurrence areas are superimposed on the map. In Fig. 15, the map is divided into five areas A to E according to the classification of the municipalities and the like. Also, the power outage occurrence positions are indicated by black dots on the map. The power outage occurrence areas are denoted as the areas A, C to E. However, among them, the areas A, D, and E in which a power outage has been detected from pieces of electronic equipment 30 equal to or more than, in number, a threshold value are indicated with emphasis by shading. In each of the areas A to E, a different number of pieces of electronic equipment 30 are installed, and accordingly, the threshold value for determining whether the area is to be indicated with emphasis may be individually set for each of the areas A to E. Also, all of the power outage occurrence areas may be indicated with emphasis. In Fig. 15, the power outage occurrence positions and the power outage occurrence areas are superimposed on the map, but the power outage occurrence positions may not be superimposed, and only the power outage occurrence areas may be superimposed.

### (C4) GUI screen C4

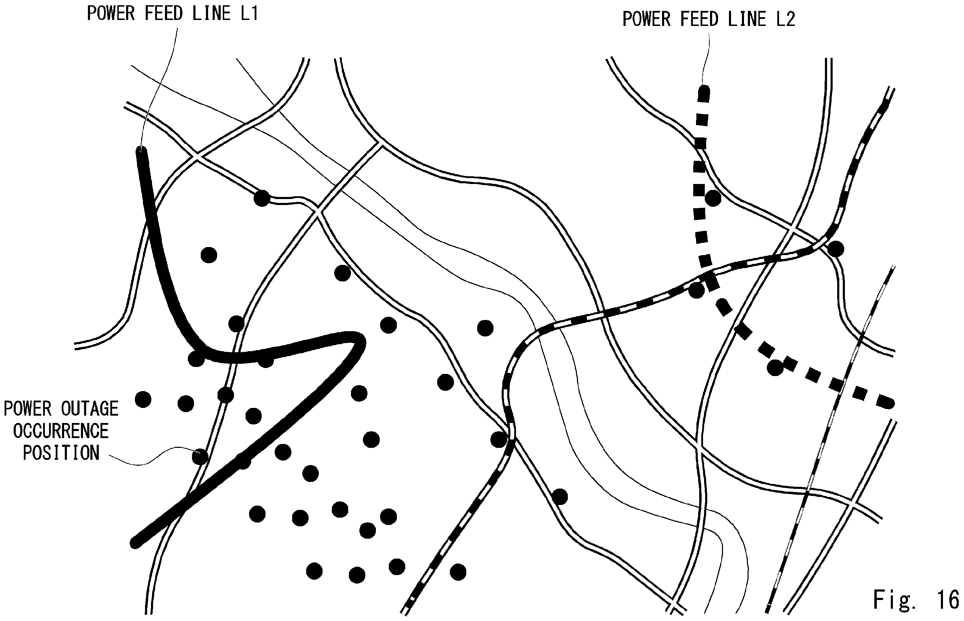

As illustrated in Fig. 16, the GUI screen C4 is a screen in which power feed lines L1, L2 connected to the power outage occurrence positions and the power outage occurrence positions are superimposed on the map. In Fig. 16, the power outage occurrence positions are indicated by black dots on the map. The power feed lines L1, L2 are indicated by lines on the map. In this case, the notification unit 23 identifies, from among the power feed lines L1, L2, the power feed line L1 as a power feed line of a high degree of priority of recovery, on the basis of a result obtained by superimposing the power outage occurrence positions and the power feed lines L1, L2 on the map. For example, in a case where the number of power outage occurrence positions detected around the power feed line L1 is greater than the number of power outage occurrence positions detected around the power feed line L2, the notification unit 23 identifies the power feed line L1 as a power feed line of a high degree of priority of recovery. Therefore, in Fig. 16, the power feed line L2 is indicated by a broken line, while the power feed line L1 is indicated by a solid line.

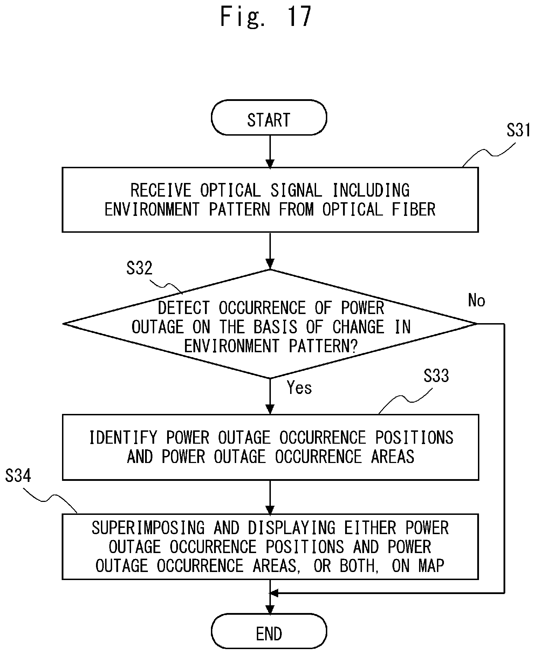

Next, an example of operation of an optical fiber sensing system according to this third example embodiment is explained with reference to Fig. 17.

As illustrated in Fig. 17, first, steps S31 to S33 the same as steps S21 to S23 of Fig. 11 are performed.

Next, the notification unit 23 causes the display unit 40 to display information of either the power outage occurrence positions or the power outage occurrence areas, or both, identified by the detection unit 22 by superimposing the information on the map information (step S34). For example, this display may be performed by the above-described GUI screens C1 to C4.

According to the above-described third example embodiment, in a case where the detection unit 22 determines that a power outage has occurred, the notification unit 23 causes the display unit 40 to display information of either the power outage occurrence positions or the power outage occurrence areas, or both, identified by the detection unit 22 by superimposing the information on the map information. Therefore, at least one of the power outage occurrence positions and the power outage occurrence areas can be notified to a communication station building, an operation center, and the like, in which the display unit 40 is provided. In this case, it is considered that, in many cases, different power companies provide power feed lines in respective areas. Therefore, if the power outage occurrence areas can be notified, the power company that provides the power feed lines in the power outage occurrence areas can be identified in a short period of time, and a request of recovery can be sent to that power company in a short period of time.

Other effects are substantially the same as, the above-described the second example embodiment.

The notification unit 23 may not only cause the display unit 40 to display the power outage occurrence positions and the power outage occurrence areas but also notify information about the power outage occurrence positions and the power outage occurrence areas by telephone, e-mail, or the like to a communication station building, an operation center, and the like.

### <Other Embodiments>

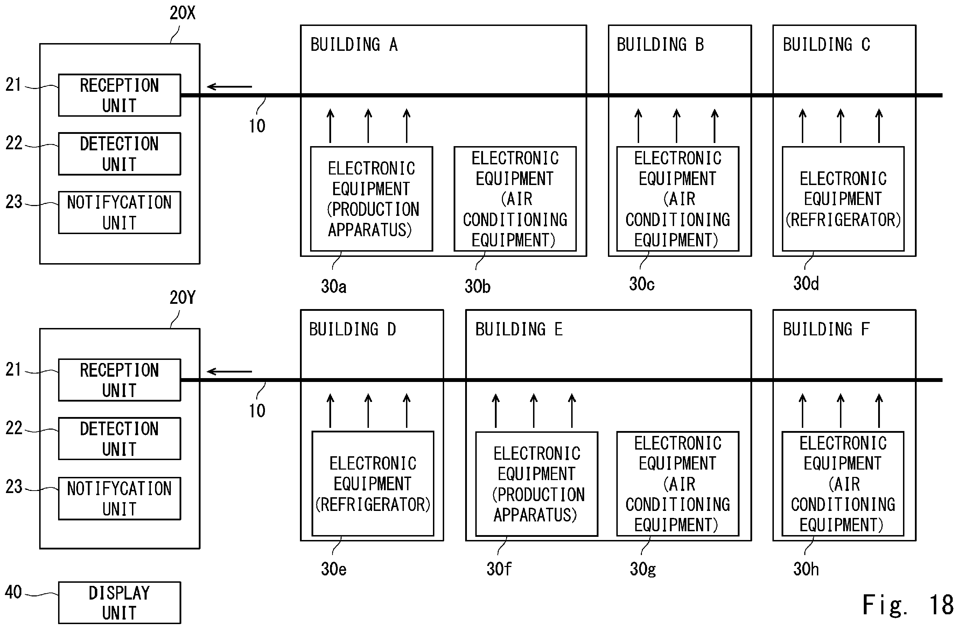

In the above-described example embodiments, the optical fiber sensing system in which only one optical fiber sensing equipment 20 is provided has been explained, but the example embodiments are not limited thereto. In the optical fiber sensing system, multiple pieces of optical fiber sensing equipment 20 may be provided. Fig. 18 illustrates an example of an optical fiber sensing system provided with two pieces of optical fiber sensing equipment 20X, 20Y that are substantially the same as the optical fiber sensing equipment 20 according to the above-described the third example embodiment. In the example of Fig. 18, the display unit 40 is shared by the two pieces of optical fiber sensing equipment 20X, 20Y, but is not limited thereto. For each of the two pieces of optical fiber sensing equipment 20X, 20Y, a display unit 40 may be individually provided.

In the above-described example embodiments, the detection unit 22 detects an occurrence of a power outage on the basis of the environment pattern included in the optical signal received by the reception unit 21, but it is considered that the reception unit 21 is unable to receive the optical signal as such. Therefore, in a case where the reception unit 21 is unable to receive the optical signal, the detection unit 22 may determine that a failure has occurred in the optical fiber 10 as such.

Also, in the above-described example embodiments, multiple components (the reception unit 21, the detection unit 22, and the notification unit 23) are provided in the optical fiber sensing equipment 20, but the example embodiments are not limited thereto. The components provided in the optical fiber sensing equipment 20 are not necessarily required to be provided in a single apparatus, and may be provided across multiple apparatuses in a distributed manner.

### <Hardware configuration of optical fiber sensing equipment>

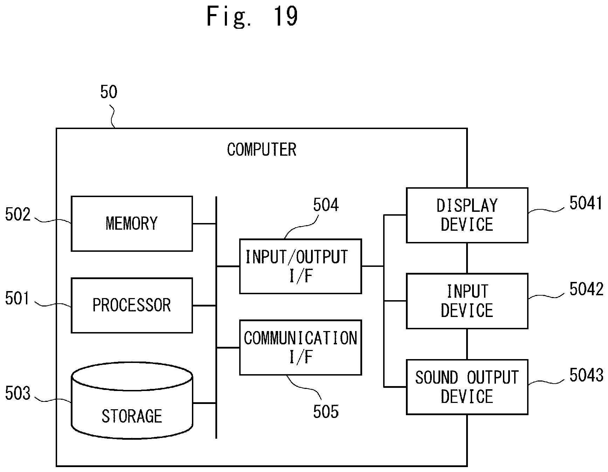

Next, hereinafter, a hardware configuration of the computer 50 that achieves the optical fiber sensing equipment 20, 20X, 20Y is explained with reference to Fig. 19.

As illustrated in Fig. 19, the computer 50 includes a processor 501, a memory 502, a storage 503, an input/output interface (an input/output I/F) 504, a communication interface (a communication I/F) 505, and the like. The processor 501, the memory 502, the storage 503, the input/output interface 504, and the communication interface 505 are connected through a data transmission line for transmitting and receiving data to and from one another.

The processor 501 is, for example, an arithmetic processing unit such as a Central Processing Unit (CPU) and a Graphics Processing Unit (GPU). The memory 502 is, for example, a memory such as a Random Access Memory (RAM) and a Read Only Memory (ROM). The storage 503 is, for example, a storage device such as a Hard Disk Drive (HDD), a Solid State Drive (SSD), and a memory card. Alternatively, the storage 503 may be a memory such as a RAM and a ROM.

The storage 503 stores programs that realize the functions of the components (the reception unit 21, the detection unit 22, and the notification unit 23) provided in the optical fiber sensing equipment 20, 20X, 20Y. The processor 501 achieves the functions of the components provided in the optical fiber sensing equipment 20 by executing these programs. In this case, when executing each of the above programs, the processor 501 may load the program on the memory 502 and then execute the program, or may execute the program without loading the program on the memory 502. In addition, the memory 502 and the storage 503 are also configured to store information and data held by the components provided in the optical fiber sensing equipment 20.

The above-described programs are stored using any of various types of non-transitory computer readable media and can be supplied to a computer (including the computer 50). The non-transitory computer readable media include various types of tangible storage media. Examples of the non-transitory computer readable media include magnetic recording media (for example, flexible discs, magnetic tapes, hard disk drives), magneto-optical recording media (for example, magneto-optical discs), Compact Disc-ROMs (CD-ROMs), CD-Recordables (CD-Rs), CD-ReWritables (CD-R/Ws), semiconductor memories (for example, mask ROMs, Programmable ROMs (PROMs), Erasable PROMs (EPROMs), flash ROMs, and RAMs. The programs may also be supplied to a computer through any of various types of transitory computer readable media. Examples of the transitory computer readable media include electrical, optical signals, and electromagnetic waves. The transitory computer readable media can supply the programs to the computer via a wired communication path, such as an electric wire and an optical fiber, or a wireless communication path.

The input/output interface 504 is connected to a display device 5041, an input device 5042, a sound output device 5043, and the like. The display device 5041 is a device that displays a screen corresponding to drawing data processed by the processor 501, such as a Liquid Crystal Display (LCD), a Cathode Ray Tube (CRT) display, and a monitor. The input device 5042 is a device that receives an operator's operation input, and is, for example, a keyboard, a mouse, a touch sensor, or the like. The display device 5041 and the input device 5042 may be integrated and realized as a touch panel. The sound output device 5043 is a device, such as a speaker, that acoustically outputs sound corresponding to acoustic data processed by the processor 501.

The communication interface 505 transmits/receives data to/from an external device. For example, the communication interface 505 communicates with an external device via a wired communication path or a wireless communication path.

Although the present disclosure has been described above with reference to the example embodiments, the present disclosure is not limited to the above-described example embodiments. Various changes that can be understood by those skilled in the art can be made to the structure and details of the present disclosure within the scope of the present disclosure.

For example, some or all of the above-described example embodiments may be used in combination.

In addition, some or all of the above-described example embodiments may also be described as in the following Supplementary Notes, but are not limited to the following.

### (Supplementary Note 1)

An optical fiber sensing system comprising:
an optical fiber;
a reception unit configured to receive, from the optical fiber, an optical signal including an environment pattern indicating a state of an environment in proximity to the optical fiber; and
a detection unit configured to detect an occurrence of a power outage, based on a change in the environment pattern.

### (Supplementary Note 2)

The optical fiber sensing system according to Supplementary Note 1, wherein in a case where the environment pattern changes to a pattern that does not include a predetermined pattern, the detection unit determines that the power outage has occurred.

### (Supplementary Note 3)

The optical fiber sensing system according to Supplementary Note 1 or 2, wherein the detection unit identifies a position where the power outage has occurred, based on a position of the optical fiber where the environment pattern has changed.

### (Supplementary Note 4)

The optical fiber sensing system according to Supplementary Note 3, wherein the detection unit identifies, as an area where the power outage has occurred, an area associated with a section including the position where the environment pattern has changed from among a plurality of areas associated with respective sections of the optical fiber.

### (Supplementary Note 5)

The optical fiber sensing system according to Supplementary Note 4, further comprising:
a display unit; and
a notification unit configured to cause the display unit to display information indicating at least one of the position and the area where the power outage has occurred by superimposing the information on the map information.

### (Supplementary Note 6)

The optical fiber sensing system according to any one of Supplementary Notes 1 to 5, wherein in a case where the environment pattern does not include a pattern indicating vibration caused by an operation of electronic equipment in proximity to the optical fiber, the detection unit determines that the power outage has occurred.

### (Supplementary Note 7)

The optical fiber sensing system according to any one of Supplementary Notes 1 to 6, wherein in a case where the environment pattern has changed based on a change in a temperature of the optical fiber, the detection unit determines that the power outage has occurred.

### (Supplementary Note 8)

An optical fiber sensing equipment comprising:
a reception unit configured to receive, from an optical fiber, an optical signal including an environment pattern indicating a state of an environment in proximity to the optical fiber; and
a detection unit configured to detect an occurrence of a power outage, based on a change in the environment pattern.

### (Supplementary Note 9)

The optical fiber sensing equipment according to Supplementary Note 8, wherein in a case where the environment pattern changes to a pattern that does not include a predetermined pattern, the detection unit determines that the power outage has occurred.

### (Supplementary Note 10)

The optical fiber sensing equipment according to Supplementary Note 8 or 9, wherein the detection unit identifies a position where the power outage has occurred, based on a position where the environment pattern has changed.

### (Supplementary Note 11)

The optical fiber sensing equipment according to Supplementary Note 10, wherein the detection unit identifies, as an area where the power outage has occurred, an area associated with a section including the position where the environment pattern has changed from among a plurality of areas associated with respective sections of the optical fiber.

### (Supplementary Note 12)

The optical fiber sensing equipment according to Supplementary Note 11, further comprising:
a notification unit configured to cause a display unit to display information indicating at least one of the position and the area where the power outage has occurred by superimposing the information on the map information.

### (Supplementary Note 13)

The optical fiber sensing equipment according to any one of Supplementary Notes 8 to 12, wherein in a case where the environment pattern does not include a pattern indicating vibration caused by an operation of electronic equipment in proximity to the optical fiber, the detection unit determines that the power outage has occurred.

### (Supplementary Note 14)

The optical fiber sensing equipment according to any one of Supplementary Notes 8 to 13, wherein in a case where the environment pattern has changed based on a change in a temperature of the optical fiber, the detection unit determines that the power outage has occurred.

### (Supplementary Note 15)

A power outage detection method achieved with an optical fiber sensing system, comprising:
a reception step of receiving, from an optical fiber, an optical signal including an environment pattern indicating a state of an environment in proximity to the optical fiber; and
a detection step of detecting an occurrence of a power outage, based on a change in the environment pattern.

### (Supplementary Note 16)

The power outage detection method according to Supplementary Note 15, wherein in the detection step, in a case where the environment pattern changes to a pattern that does not include a predetermined pattern, it is determined that the power outage has occurred.

### (Supplementary Note 17)

The power outage detection method according to Supplementary Note 15 or 16, wherein in the detection step, a position where the power outage has occurred is identified based on a position where the environment pattern has changed.

### (Supplementary Note 18)

The power outage detection method according to Supplementary Note 17, wherein in the detection step, an area associated with a section including the position where the environment pattern has changed is identified, as an area where the power outage has occurred, from among a plurality of areas associated with respective sections of the optical fiber.

### (Supplementary Note 19)

The power outage detection method according to Supplementary Note 18, further comprising a display step of causing a display unit to display information indicating at least one of the position and the area where the power outage has occurred by superimposing the information on the map information.

### (Supplementary Note 20)

The power outage detection method according to any one of Supplementary Notes 15 to 19, wherein in the detection step, in a case where the environment pattern does not include a pattern indicating vibration caused by an operation of electronic equipment in proximity to the optical fiber, it is determined that the power outage has occurred.

### (Supplementary Note 21)

The power outage detection method according to any one of Supplementary Notes 15 to 20, wherein in the detection step, in a case where the environment pattern has changed based on a change in a temperature of the optical fiber, it is determined that the power outage has occurred.

The present application claims the benefit of priority of Japanese Patent Application No. 2019-148297 filed on August 13, 2019, the entire content of which is incorporated herein by reference.

### Reference Signs List

- 10: OPTICAL FIBER
- 20, 20X, 20Y: OPTICAL FIBER SENSING EQUIPMENT
- 21: RECEPTION UNIT
- 22: DETECTION UNIT
- 23: NOTIFICATION UNIT
- 30, 30a TO 30h: ELECTRONIC EQUIPMENT
- 40: DISPLAY UNIT
- 50: COMPUTER
- 501: PROCESSOR
- 502: MEMORY
- 503: STORAGE
- 504: INPUT/OUTPUT INTERFACE
- 5041: DISPLAY DEVICE
- 5042: INPUT DEVICE
- 5043: SOUND OUTPUT DEVICE
- 505: COMMUNICATION INTERFACE

## Claims

1. An optical fiber sensing system comprising:
an optical fiber;
a reception unit configured to receive, from the optical fiber, an optical signal including an environment pattern indicating a state of an environment in proximity to the optical fiber; and
a detection unit configured to detect an occurrence of a power outage, based on a change in the environment pattern.

2. The optical fiber sensing system according to Claim 1, wherein in a case where the environment pattern changes to a pattern that does not include a predetermined pattern, the detection unit determines that the power outage has occurred.

3. The optical fiber sensing system according to Claim 1 or 2, wherein the detection unit identifies a position where the power outage has occurred, based on a position of the optical fiber where the environment pattern has changed.

4. The optical fiber sensing system according to Claim 3, wherein the detection unit identifies, as an area where the power outage has occurred, an area associated with a section including the position where the environment pattern has changed from among a plurality of areas associated with respective sections of the optical fiber.

5. The optical fiber sensing system according to Claim 4, further comprising:
a display unit; and
a notification unit configured to cause the display unit to display information indicating at least one of the position and the area where the power outage has occurred by superimposing the information on the map information.

6. The optical fiber sensing system according to any one of Claims 1 to 5, wherein in a case where the environment pattern does not include a pattern indicating vibration caused by an operation of electronic equipment in proximity to the optical fiber, the detection unit determines that the power outage has occurred.

7. The optical fiber sensing system according to any one of Claims 1 to 6, wherein in a case where the environment pattern has changed based on a change in a temperature of the optical fiber, the detection unit determines that the power outage has occurred.

8. An optical fiber sensing equipment comprising:
a reception unit configured to receive, from an optical fiber, an optical signal including an environment pattern indicating a state of an environment in proximity to the optical fiber; and
a detection unit configured to detect an occurrence of a power outage, based on a change in the environment pattern.

9. The optical fiber sensing equipment according to Claim 8, wherein in a case where the environment pattern changes to a pattern that does not include a predetermined pattern, the detection unit determines that the power outage has occurred.

10. The optical fiber sensing equipment according to Claim 8 or 9, wherein the detection unit identifies a position where the power outage has occurred, based on a position where the environment pattern has changed.

11. The optical fiber sensing equipment according to Claim 10, wherein the detection unit identifies, as an area where the power outage has occurred, an area associated with a section including the position where the environment pattern has changed from among a plurality of areas associated with respective sections of the optical fiber.

12. The optical fiber sensing equipment according to Claim 11, further comprising:
a notification unit configured to cause a display unit to display information indicating at least one of the position and the area where the power outage has occurred by superimposing the information on the map information.

13. The optical fiber sensing equipment according to any one of Claims 8 to 12, wherein in a case where the environment pattern does not include a pattern indicating vibration caused by an operation of electronic equipment in proximity to the optical fiber, the detection unit determines that the power outage has occurred.

14. The optical fiber sensing equipment according to any one of Claims 8 to 13, wherein in a case where the environment pattern has changed based on a change in a temperature of the optical fiber, the detection unit determines that the power outage has occurred.

15. A power outage detection method achieved with an optical fiber sensing system, comprising:
a reception step of receiving, from an optical fiber, an optical signal including an environment pattern indicating a state of an environment in proximity to the optical fiber; and
a detection step of detecting an occurrence of a power outage, based on a change in the environment pattern.

16. The power outage detection method according to Claim 15, wherein in the detection step, in a case where the environment pattern changes to a pattern that does not include a predetermined pattern, it is determined that the power outage has occurred.

17. The power outage detection method according to Claim 15 or 16, wherein in the detection step, a position where the power outage has occurred is identified based on a position where the environment pattern has changed.

18. The power outage detection method according to Claim 17, wherein in the detection step, an area associated with a section including the position where the environment pattern has changed is identified, as an area where the power outage has occurred, from among a plurality of areas associated with respective sections of the optical fiber.

19. The power outage detection method according to Claim 18, further comprising a display step of causing a display unit to display information indicating at least one of the position and the area where the power outage has occurred by superimposing the information on the map information.

20. The power outage detection method according to any one of Claims 15 to 19, wherein in the detection step, in a case where the environment pattern does not include a pattern indicating vibration caused by an operation of electronic equipment in proximity to the optical fiber, it is determined that the power outage has occurred.

21. The power outage detection method according to any one of Claims 15 to 20, wherein in the detection step, in a case where the environment pattern has changed based on a change in a temperature of the optical fiber, it is determined that the power outage has occurred.
